# EUROPEAN PATENT SPECIFICATION

(11) **EP 4 220 812 B1**
(45) Date of publication and mention of the grant of the patent: **12.03.2025**
(21) Application number: 22853433.5
(22) Date of filing: 02.08.2022
(51) Int. Cl.: G01R 31/389, G01R 31/52, G01R 31/66, H01M 10/42, H01M 10/48

(54) **APPARATUS AND METHOD FOR INSPECTING DISCONNECTION OF ELECTRODE TAB OF BATTERY CELL**
VORRICHTUNG UND VERFAHREN ZUM PRÜFEN DER TRENNUNG DER ELEKTRODENLASCHE EINER BATTERIEZELLE
APPAREIL ET PROCÉDÉ POUR CONTRÔLER LA DÉCONNEXION DE LANGUETTE D'ÉLÉCTRODE D'UNE CELLULE DE BATTERIE

(30) Priority: 06.08.2021 KR 20210104021
(43) Date of publication of application: 02.08.2023
(73) Proprietor: LG Energy Solution, Ltd., Seoul 07335 (KR)
(72) Inventor: PARK, Sang Dae, Daejeon 34122 (KR); KIM, Ju Young, Daejeon 34122 (KR); LEE, Ju Mi, Daejeon 34122 (KR); CHO, In Hwan, Daejeon 34122 (KR)
(74) Representative: Plasseraud IP
(86) International application number: PCT/KR2022/011408
(87) International publication number: WO 2023/014056

(56) References cited:
- KR-A- 20130 012 569
- KR-A- 20180 002 224
- KR-A- 20190 048 000
- KR-A- 20200 035 594
- KR-A- 20200 035 594
- KR-B1- 100 770 727
- US-A1- 2021 132 154

## Description

### [Technical Field]

The present invention relates to an apparatus and method for inspecting disconnection of an electrode tab of a battery cell for non-destructively inspecting disconnection of an electrode tab of a battery cell.

This application claims the benefit of priority based on Korean Patent Application No. 10-2021-0104021, filed on August 6, 2021.

### [Background Art]

Recently, secondary batteries capable of charging and discharging have been widely used as energy sources of wireless mobile devices. Further, secondary batteries have been drawing attention as energy sources of electric vehicles, hybrid electric vehicles, and the like proposed as solutions to solve air pollution of existing gasoline vehicles, diesel vehicles, and the like using fossil fuels. Accordingly, kinds of applications using secondary batteries have diversified due to the advantages of secondary batteries, and in the future, secondary batteries are expected to be applied to even more fields and products.

Such secondary batteries can be classified into lithium-ion batteries, lithium-ion polymer batteries, lithium polymer batteries, and the like according to an electrode and a composition of an electrolyte, and among them, the usage of lithium-ion polymer batteries in which the possibility of electrolyte leakage is small and which are easily manufactured is increasing. In general, secondary batteries are classified according to a shape of a battery case, including cylindrical batteries and prismatic batteries in which electrode assemblies are installed in cylindrical or prismatic metal cans and pouch-type batteries in which electrode assemblies are installed in pouch-type cases formed of aluminum laminate sheets. An electrode assembly installed in a battery case is formed as a structure which includes a positive electrode, a negative electrode, and a separation membrane interposed therebetween, is a power generating element capable of charging and discharging, and is classified into a jelly-roll type in which a separation membrane is interposed between a positive electrode and a negative electrode having long sheet shapes coated with active materials and wound and a stack type in which a plurality of positive and negative electrodes having predetermined sizes are sequentially stacked in a state in which separation membranes are interposed therebetween.

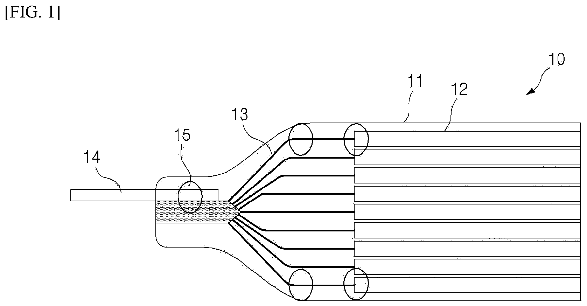

FIG. 1 is a schematic view showing locations at which electrode tabs 13 of a pouch-type battery cell 10 are disconnected.

As illustrated in the drawing, an electrode assembly 12 is installed in a battery case 11 of the pouch-type battery cell 10, and the electrode tabs 13 are withdrawn from the electrode assembly 12 and welded to an electrode lead 14. Since welding portions of the electrode tabs and tabs and welding portions of the electrode tabs and the electrode lead receive forces in various directions during a manufacturing process of the battery cell, disconnection 15 may occur at one or several welding portions among the welding portions. When disconnection occurs, it may cause a defect such as a low voltage.

In order to detect the disconnection of the electrode tab, conventionally, as in Patent Document 1, a method of pressing a battery cell and measuring an impedance change according to the pressing or physically inspecting a welding location by capturing a computed tomography (CT) image has been used.

In the technology of Patent Document 1, since a separate pressing device which presses the battery cell is required to measure the impedance change, it has been difficult to apply the method to mass-production level inspection.

In addition, in the case of the capturing of the CT image, since it takes about 1 minute and 30 seconds to inspect each battery cell, mass-production level inspection is impossible.

Accordingly, development of a battery cell electrode tab disconnection inspecting technology in which a battery cell is not pressed and a long time is not taken to inspect and which can be quickly performed at a mass-production level is required.

### [Related Art]

### [Patent Document]

Korean Patent Publication No. 10-2020-0035594

### [Disclosure]

### [Technical Problem]

An object of the present invention is to provide an apparatus and method for inspecting disconnection of an electrode tab of a battery cell capable of inspecting disconnection of an electrode tab within a short time.

### [Technical Solution]

An apparatus for inspecting disconnection of an electrode tab of a battery cell according to the present invention includes: a measurement part which measures impedance values and impedance angles according to the frequency of an inspection target battery cell; a calculation part which calculates real part resistance values of impedance according to the frequency of the inspection target battery cell from the impedance values and the impedance angles; and a determination part which determines whether an electrode tab of the battery cell is disconnected by comparing real part resistance values in a real part resistance value range in a resonance frequency range of good battery cells having the same type as the inspection target battery cell with the real part resistance values of the impedance of the inspection target battery cell in the same frequency range as the resonance frequency range.

As one example, when the real part resistance values of the impedance of the inspection target battery cell in the same frequency range as the resonance frequency range are greater than the real part resistance values in the real part resistance value range in the resonance frequency range of the good battery cells, the determination part may determine that the electrode tab of the inspection target battery cell is disconnected.

As one example, the measurement part may be an electrochemical impedance spectroscopy (EIS) meter.

As a specific example, when a part of the real part resistance value range of the good battery cells in the resonance frequency range overlaps a change line of real part resistance values of a defective battery cell or a real part resistance value range of the defective battery cells in the same frequency range as the resonance frequency range, the determination part may check whether the electrode tab of the inspection target battery cell is disconnected by comparing the real part resistance values in the real part resistance value range of the good battery cells including or excluding the overlapping change line or range with the real part resistance values of the inspection target battery cell.

As another example, the determination part may determine whether the electrode tab of the inspection target battery cell is disconnected by determining real part resistance values in a real part resistance value range of the good battery cells based on frequency data of the resonance frequency range of the good battery cells and real part resistance value data in the resonance frequency range and comparing the real part resistance values in the real part resistance value range of the good battery cells with the real part resistance values of the inspection target battery cell.

In addition, the apparatus for inspecting disconnection of an electrode tab of a battery cell may further include a storage part in which information on at least one of the resonance frequency range of the plurality of battery cells, the real part resistance value range of the good battery cells in the resonance frequency range, and a correlation between frequencies and real part resistance values in the resonance frequency range is stored.

A method for inspecting disconnection of an electrode tab of a battery cell according to another aspect of the present invention includes: measuring impedance values and impedance angles according to the frequency of an inspection target battery cell; calculating real part resistance values of impedance according to the frequency of the inspection target battery cell from the impedance values and the impedance angles; and determining whether an electrode tab of the inspection target battery cell is disconnected by comparing real part resistance values in a real part resistance value range in a resonance frequency range of good battery cells having the same type as the inspection target battery cell with the real part resistance values of the impedance of the inspection target battery cell in the same frequency range as the resonance frequency range.

The resonance frequency range of the good battery cells may be a range including frequencies at which an imaginary part resistance of a measured impedance value of each of the plurality of good battery cells changes from a positive (+) value to a negative (-) value.

As one example, the method may including deriving a real part resistance value line of good product impedance of the individual good battery by connecting real part resistance values according to the frequency in the resonance frequency range of each of the good battery cells , and setting a real part resistance value zone of the good battery cells, of which real part resistance value lines of good product impedance are adjacent, to the real part resistance value range in the resonance frequency range of the good battery cells.

Specifically, the determining may include determining the inspection target battery cell to be a defective product when the real part resistance values of the impedance of the inspection target battery cell in the same frequency range as the resonance frequency range are greater than the real part resistance values of the real part resistance value zone of the good battery cells and determining the inspection target battery cell to be a good product when the real part resistance values of the impedance of the inspection target battery cell in the same frequency range as the resonance frequency range are smaller than or equal to a range of the real part resistance values of the real part resistance value zone.

Alternatively, the determining may include determining whether the inspection target battery cell is good or bad by comparing real part resistance values in the real part resistance value zone of the good battery cells with real part resistance values of the inspection target battery cell at three points of a minimum frequency, a middle frequency, and a maximum frequency in the resonance frequency range.

As a specific example, the method may include deriving a defective product real part resistance value line of an individual battery cell or a defective real part resistance value zone in which real part resistance value lines of a plurality of defective battery cells are adjacent by connecting real part resistance values according to the frequency of each of the plurality of defective battery cells in which electrode tabs are disconnected ; and setting, when the defective product real part resistance value line or the defective product real part resistance value zone overlaps the real part resistance value zone of the good battery cells, a range including or excluding the overlapping zone as a real part resistance value range of the good battery cells for determining whether the battery cell is good or bad.

As another example, the method may include deriving a correlation between frequencies and the real part resistance values in the resonance frequency range from frequency data and real part resistance value data in the resonance frequency range of the plurality of good battery cells, and setting a real part resistance value range in the resonance frequency range based on the derived correlation to a real part resistance value range in the resonance frequency range of the good battery cells.

As one example, the determining may include determining the inspection target battery cell to be a good product when the real part resistance values of the impedance of the inspection target battery cell in the same frequency range as the resonance frequency range are greater than the real part resistance value in the resonance frequency range of the good battery cells based on the correlation, and determining the inspection target battery cell to be a defective product when the real part resistance values of the impedance of the inspection target battery cell in the same frequency range as the resonance frequency range are smaller than the real part resistance value range in the resonance frequency range of the good battery cells based on the correlation,

As another example, the determining may include determining whether the battery cell is good or bad by comparing real part resistance values of the good products expressed according to the correlation at three points of a minimum frequency, a middle frequency, and a maximum frequency of the resonance frequency range with real part resistance values of the inspection target battery cell at the three frequencies.

The determining may include determining the inspection target battery cell to be a defective product when the real part resistance values of the impedance of the inspection target battery cell in the same frequency range as the resonance frequency range are greater than the real part resistance values in the resonance frequency range of the good battery cells based on the correlation by a predetermined range or more.

### [Advantageous Effects]

According to the present invention, since disconnection of an electrode tab can be quickly inspected, mass-production level inspection can be performed. Further, due the disconnection inspection of the present invention, a defective battery cell can be prevented from being shipped.

Further, according to the present invention, not only can the quick inspection be performed in a battery cell manufacturing stage, but a defect (disconnection of the electrode tab) of the battery cell in a recycling stage or reuse stage in which a finished battery cell is used again after a certain period of use can also be quickly inspected. Accordingly, when the battery cell is recycled, whether the battery is to be used can be determined simply by quickly inspecting the battery cell for defects.

### [Brief Description of the Drawings]

FIG. 1 is a schematic view showing locations at which electrode tabs of a pouch-type battery cell are disconnected.
FIG. 2 is a graph showing an example of a Nyquist plot of a battery cell.
FIG. 3 is a graph showing an impedance value on a complex plane.
FIG. 4 is a schematic diagram illustrating an apparatus for inspection disconnection of an electrode tab of a battery cell of the present invention.
FIG. 5 is a flowchart illustrating a process of setting a real part resistance value range of good battery cells applied to a method for inspecting disconnection of an electrode tab of a battery cell of the present invention.
FIG. 6 is a graph for describing a process of obtaining a real part resistance value range and determining whether a battery cell is good or bad according to a method for inspecting disconnection of an electrode tab of one embodiment of the present invention.
FIG. 7 is a graph for describing a process of obtaining a real part resistance value range and determining whether a battery cell is good according to a method for inspecting disconnection of an electrode tab of another embodiment of the present invention.

### [Detailed Description of the Preferred Embodiments]

Hereinafter, the present invention will be described in detail. First, terms and words used in this specification and claims should not be interpreted as limited to commonly used meanings or meanings in dictionaries and should be interpreted with meanings and concepts which are consistent with the technological scope of the invention based on the principle that the inventors have appropriately defined concepts of terms in order to describe the invention in the best way.

In this application, it should be understood that terms such as "include" or "have" are intended to indicate that there is a feature, number, step, operation, component, part, or a combination thereof described in the specification, and they do not exclude in advance the possibility of the presence or addition of one or more other features or numbers, steps, operations, components, parts or combinations thereof. In addition, when a portion, such as a layer, a film, an area, a plate, etc., is referred to as being "on" another portion, this includes not only the case where the portion is "directly on" another portion but also the case where still another portion is interposed therebetween. On the other hand, when a portion, such as a layer, a film, an area, a plate, etc., is referred to as being "under" another portion, this includes not only the case where the portion is "directly under" another portion but also the case where still another portion is interposed therebetween. In addition, to be disposed "on" in the present application may include being disposed at the bottom as well as the top.

Meanwhile, in the present specification, "a longitudinal direction" is a direction in which an electrode lead of a battery cell protrudes.

When an electrode tab of a battery cell is disconnected as in FIG. 1, it is estimated that there may be a change in impedance value of the battery cell. Based on this, a method of detecting whether disconnection occurs by pressing the battery cell and measuring an impedance change is adopted in Patent Document 1.

However, as described above, the present invention is intended to detect whether disconnection occurs based on impedance without applying pressure. Even when an impedance change occurs due to the disconnection, since impedance is a value that varies according to a frequency, a frequency at which whether the disconnection occurs is test based on impedance should be specified.

A resonance frequency is a frequency at which a reactance component of impedance is zero. That is, the resonance frequency is a frequency at which an imaginary component of the impedance is zero. Resonance frequencies of battery cells are not the same 100% but vary according to a shape, a chemical composition, and a type of a battery cell. That is, the resonance frequency of the battery cell is one parameter indicating a characteristic or physical property of the battery cell. Accordingly, the inventor predicted that a change in a physical property of a battery cell may be observed by measuring impedance at a resonance frequency. Disconnection of an electrode tab of a battery cell may also be one example of the change in the physical property. The starting point of the present invention is that, when an impedance value at a resonance frequency of a good battery cell in which an electrode tab is not disconnected is obtained, whether an electrode tab is disconnected may be inspected quickly and simply by comparing the impedance value with that of a inspection target battery cell.

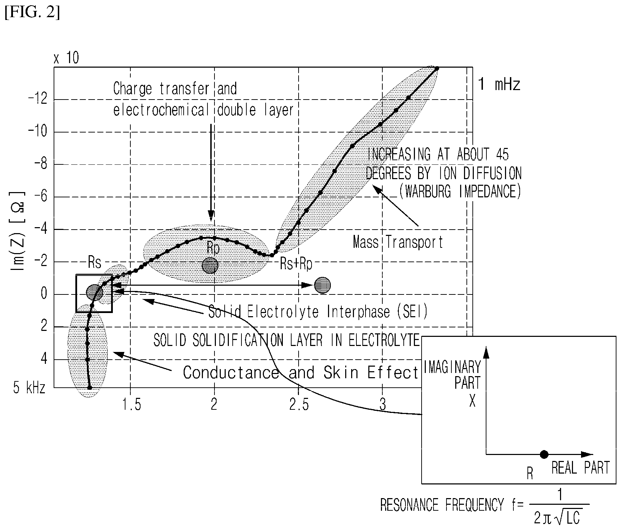

FIG. 2 is a graph showing an example of a Nyquist plot of a battery cell. When small AC signals having different frequencies are applied to a specific battery cell using an impedance measuring device, for example, an electrochemical impedance spectroscopy (EIS) meter, the Nyquist plot as in FIG. 2 may be obtained. However, although actual points measured by the EIS meter are limited to the number of frequencies, the plot as in FIG. 2 may be obtained through appropriate curve fitting. In this case, a resonance frequency is a frequency of a point at which an imaginary part resistance of an impedance is zero. That is, when an impedance of the battery cell is measured using the EIS meter, a frequency at which an imaginary part resistance of an impedance value changes from a positive (+) value to a negative (-) value (or vice versa) is the resonance frequency. That is, in FIG. 2, a resistance Rs is the impedance at the resonance frequency, that is, a real part resistance value.

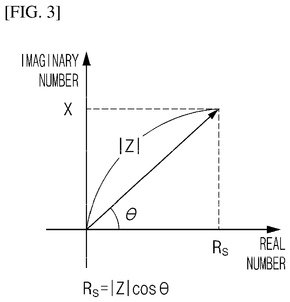

FIG. 3 is a graph showing an impedance value illustrated on a complex plane. As in FIG. 3, a real part resistance Rs of an impedance is expressed as |Z|cosθ. The present invention is premised on obtaining a range of resonance frequencies (resonance frequency range) of good battery cells and extracting a real part resistance value range of the good battery cells in the resonance frequency range. In a state in which such resistance value data of good products is provided, when real part resistance values according to the frequency of an inspection target battery cell 10 are obtained and compared with the real part resistance values of the good products in the same frequency range (resonance frequency range), a defective product, that is, a battery cell in which disconnection has occurred in an electrode tab, can be easily checked.

Hereinafter, the present invention will be described in detail.

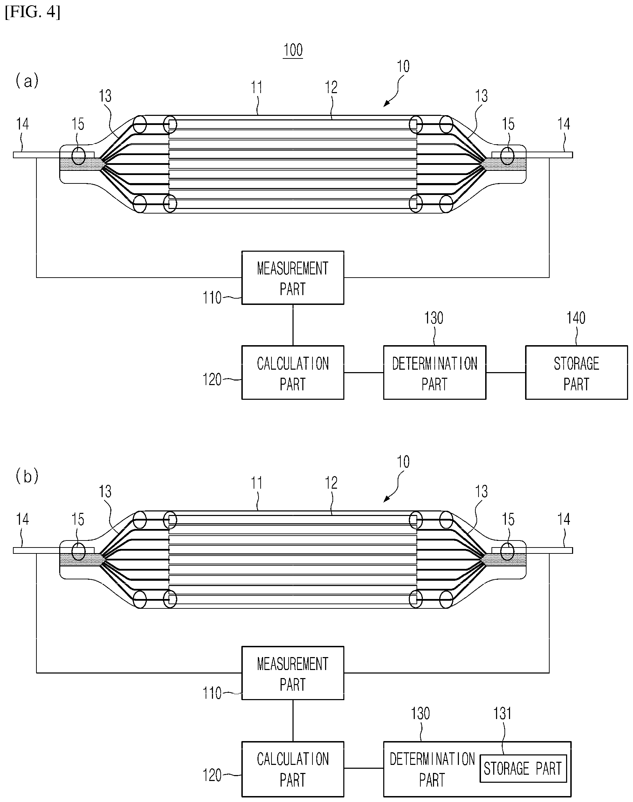

FIG. 4 is a schematic diagram illustrating an apparatus for inspecting disconnection of an electrode tab of a battery cell of the present invention.

An electrode tab disconnection inspecting apparatus 100 for a battery cell 10 according to the present invention includes a measurement part 110 which measures impedance values and impedance angles according to the frequency of an inspection target battery cell 10; a calculation part 120 which calculates real part resistance values Rs of impedance according to the frequency of the inspection target battery cell 10 from the impedance values and the impedance angles; and a determination part which determines whether an electrode tab of the inspection target battery cell 10 is disconnected by comparing real part resistance values Rs in a real part resistance value range in a resonance frequency range of good battery cells having the same type as the inspection target battery cell 10 with the real part resistance values Rs of the impedance of the inspection target battery cell 10 in the same frequency range as the resonance frequency range.

The electrode tab disconnection inspecting apparatus 100 of the present invention includes the measurement part 110. The measurement part 110 may be an EIS meter. According to the EIS meter, impedance parameters for various frequencies may be obtained as described above. For example, an impedance Z, a reactance X, an impedance angle θ, a voltage, a temperature, and the like may be obtained. In addition, a resonance frequency, which is a frequency of a point at which a sign of a reactance, which is an imaginary part resistance, changes may also be checked. The measurement part 110 may measure the impedance values and the impedance angles according to the frequency of the inspection target battery cell 10.

In addition, the electrode tab disconnection inspecting apparatus 100 of the present invention includes the calculation part 120 which calculates the real part resistance values Rs of the impedance according to the frequency of the inspection target battery cell 10 from the impedance values and the impedance angles. When an impedance Z and an impedance angle θ are known, real part resistance values Rs may be obtained through the above equation Rs=|Z|cosθ. That is, the plurality of real part resistance values Rs can be obtained according to a change in frequency.

The present invention includes the determination part which compares the real part resistance values Rs of the impedance of the inspection target battery cell 10 with the real part resistance values Rs of the good battery cells in the real part resistance value range in the resonance frequency range. The good product real part resistance value range in the resonance frequency range of the good battery cells having the same type as the inspection target battery cell 10 has been obtained in advance using the EIS meter. Setting of the good product real part resistance value range will be described below in relation to a method for inspecting disconnection of an electrode tab of a battery cell of the present invention.

**In** order to check whether the electrode tab is disconnected, a real part resistance value Rs is selected from the real part resistance values Rs of the inspection target battery cell 10 in the same frequency range as the resonance frequency range of the good battery cells. Since the inspection target battery cell 10 is the same type battery cell as the good products, a resonance frequency of the inspection target battery cell 10 is highly likely to be in the resonance frequency range of the good products. However, according to an internal state of the battery cell, the resonance frequency of the inspection target battery cell 10 may not be in the resonance frequency range. However, in the present invention, since real part resistance value data of the good products verified through a plurality of good battery cells is compared with that of the inspection target battery cell 10, the resonance frequency of the inspection target battery cell 10 does not necessarily need to be in the resonance frequency range of the good products. That is, among the frequencies at which the inspection target battery cell 10 is measured, the frequency range in which the inspection target battery cell 10 is measured is acceptable when the frequency range is the same as the resonance frequency range of the good products, and whether the electrode tab of the inspection target battery cell 10 is disconnected may be quickly determined when the real part resistance value Rs of the impedance of the inspection target battery cell 10 in the frequency range is compared with the real part resistance value range of the good products. In this case, since the real part resistance values in a specific frequency range of the inspection target battery cell 10 measured by the EIS meter is only compared with the preset good product real part resistance value range, battery cells do not need to be pressed. Accordingly, whether the battery cell is disconnected may be simply inspected through an algorithm or computing program which performs measurement using the measurement part 110, calculates the real part resistance values Rs using the calculation part 120, and performs comparison using the determination part 130. In this aspect, since the electrode tab disconnection inspecting apparatus 100 of the present invention can quickly perform inspection at a level applicable to mass production, the electrode tab disconnection inspecting apparatus 100 is very advantageous for factory automation.

As a specific example, there is a case in which a part of the real part resistance value range of the good battery cells in the resonance frequency range overlaps a change line of a real part resistance value of a defective battery cell in the same frequency range as the resonance frequency range or a real part resistance value range of a defective battery cell. That is, the real part resistance value range of the good products is not necessarily completely differentiated from a real part resistance value Rs of the defective product. The overlap of the real part resistance value range between the good products and the defective product becomes severe in a low frequency range, as will be described below. However, the overlap is much smaller in the resonance frequency range as will be described below, and this is also a reason for comparing the real part resistance Rs in the resonance frequency range.

The determination part 130 may check whether the electrode tab of the inspection target battery cell 10 is disconnected by comparing the real part resistance values Rs in the real part resistance value range including the overlapping change line or excluding the overlapping range of the good battery cells with the real part resistance values Rs of the inspection target battery cell 10. For example, in the case of a battery cell in a field in which quality standards are strict and a very high safety level is required, whether disconnection occurs is inspected by comparing only the good product real part resistance value range, which excludes a range overlapping a change line of a real part resistance value or a resistance value range of a defective product, of the good products with the real part resistance values Rs of the inspection target battery cell 10. In this case, although battery cells with good quality may also be regarded as defective products and discarded, the battery cells having overlapping real part resistance values Rs are also regarded as defective products when safety is prioritized.

On the other hand, in the case of a battery cell in a field in which quality standards and safety are not required to be relatively high, whether disconnection occurs is checked by considering all products having good product real part resistance values Rs in the overlapping range as being included in a good product range from a viewpoint of product productivity. In this case, although there is a possibility that a defective battery cell in which disconnection occurs may be determined to be a good product, productivity and safety are weighted and compared, and the possibility is accepted.

On the other hand, the determination part 130 may check whether the electrode tab of the inspection target battery cell 10 is disconnected by comparing real part resistance values Rs in a real part resistance value range of the good battery cells derived on the basis of a correlation between frequency data of the resonance frequency range of the good battery cells and real part resistance value data in the resonance frequency range with the real part resistance values Rs of the inspection target battery cell 10. For example, a plurality of pieces of real part resistance value data may be obtained for a plurality of frequencies for each good battery. In this case, when the frequency data and the resistance value data are plotted on a coordinate plane, several scattered data points will be shown. For example, a correlation between the frequency data and the real part resistance value data may be obtained using linear regression analysis. When such a correlation is obtained, one function or correlation may be derived in the resonance frequency range of the plurality of battery cells. Then, since the real part resistance value range of the good products according to the single correlation is compared with that of the inspection target battery cell, whether disconnection occurs can be inspected more quickly and accurately. A more detailed description thereof will be provided in relation to a method for inspecting disconnection of an electrode tab of the present invention.

The electrode tab disconnection inspection apparatus 100 of the present invention may also include a storage part 140 which stores information on at least one among the resonance frequency range of the plurality of battery cells, the real part resistance value range of the good battery cells in the resonance frequency range, and the correlation between the frequency and the real part resistance values Rs in the resonance frequency range. As illustrated in FIG. 4, the storage part 140 may be provided as a type of a server or database (DB) separated from the determination part 130 (see FIG. 4A). Alternatively, a storage part 131 may be included in a determination part 130 as a type of a memory (see FIG. 4B).

As in FIG. 4, whether disconnection occurs may be quickly inspected by measuring the impedance values and the impedance angles according to the frequency of the inspection target battery cell 10 using the measurement part 110, calculating the real part resistance value Rs according to the frequency from the values using the calculation part 120, and comparing the real part resistance values Rs in the real part resistance value range in the resonance frequency range of the good battery cells with the real part resistance values Rs of the inspection target battery cell 10 in the same frequency range using the determination part 130. Each of the calculation part 120 and the determination part 130 may be a computing device realized by controlling hardware including a computing device, such as a central processing unit (CPU) or a micro controller unit (MCU), and a storage device, such as a hard disk, using predetermined software, and the calculation part 120 and the determination part 130 are set to communicate with each other. In addition, according to the embodiment, the calculation part 120 and the determination part 130 may also be implemented as one processor.

Hereinafter, a method for inspecting disconnection of an electrode tab of a battery cell will be described according to the present invention.

The method for inspecting disconnection of an electrode tab of the present invention includes: measuring impedance values and impedance angles according to the frequency of an inspection target battery cell; calculating real part resistance values Rs of impedance according to the frequency of the inspection target battery cell from the impedance values and the impedance angles; and determining whether an electrode tab of the inspection target battery cell is disconnected by comparing real part resistance values of a real part resistance value range in a resonance frequency range of good battery cells having the same type as the inspection target battery cell with the real part resistance values of the impedance of the inspection target battery cell in the same frequency range as the resonance frequency range.

First, as in FIG. 2, when the inspection target battery cell is connected to the measurement part 110 such as the EIS meter, the impedance values and the impedance angles according to the frequency of the inspection target battery cell are measured. As described above, since the EIS meter may measure various parameters related to impedance, the EIS meter may measure the impedance values and the impedance angles.

Next, the real part resistance values Rs of the impedance according to the frequency of the inspection target battery cell are calculated from the impedance values and the impedance angles. For example, the calculation part 120 in which a predetermined computing program is installed may mechanically and automatically calculate the real part resistance values Rs of the impedance according to the frequency of the inspection target battery cell through the predetermined equation shown in FIG. 3.

Finally, whether the electrode tab of the inspection target battery cell is disconnected is determined by comparing the real part resistance values Rs in the real part resistance value range in the resonance frequency range of the good battery cells having the same type as the inspection target battery cell with the real part resistance values Rs of the impedance of the inspection target battery cell in the same frequency range as the resonance frequency range.

In this determination, the real part resistance values Rs in the real part resistance value range in the resonance frequency range of the good battery cells having the same type as the inspection target battery cell are compared with those of the inspection target battery cell. Accordingly, information on the resonance frequency range of the good battery cells and information on the good product real part resistance value range in the resonance frequency range are required. In addition, the method of determining whether disconnection occurs may be slightly different according to what type of good product real part resistance value range is obtained.

The information should be obtained in advance before the inspection target battery cell is inspected. Hereinafter, the obtaining of the information and a method for inspecting disconnection or a determination method related to obtaining such information will be described.

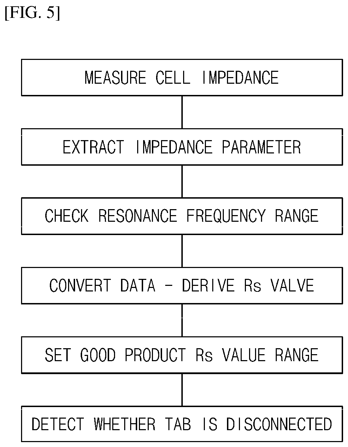

FIG. 5 is a flowchart illustrating a process of setting a real part resistance value range of good battery cells applied to a method for inspecting disconnection of an electrode tab of a battery cell of the present invention.

First, impedance values and impedance angles of a plurality of good battery cells in which there is no disconnection in electrode tabs of the battery cells are measured while changing a frequency. As described above, this process may be performed using the EIS meter. Thereby, the above-described impedance parameters may be obtained.

Thereafter, a resonance frequency of each battery cell is extracted to derive a resonance frequency range for the plurality of good battery cells. In this case, the resonance frequency range of the good battery cells is a range including frequencies at which an imaginary part resistance of the measured impedance value of each of the plurality of good battery cells changes from a positive (+) value to a negative (-) value. Since the resonance frequencies are slightly different even when the battery cells are the same type, when the resonance frequency of each of the plurality of battery cells is obtained, the entire resonance frequency range is obtained. This is determined to be a resonance frequency range for a corresponding good battery cell.

Next, real part resistance values Rs of impedance of the plurality of good battery cells are calculated from the impedance values and the impedance angles through the equation of FIG. 3.

In addition, a real part resistance value range of the good battery cells in the resonance frequency range is set from the resonance frequency range and the calculated Rs values.

There are two embodiments related to the setting of the real part resistance value range that will be described below. A method for inspecting disconnection may vary in each embodiment.

### [Form for implementation of the invention]

### (First embodiment)

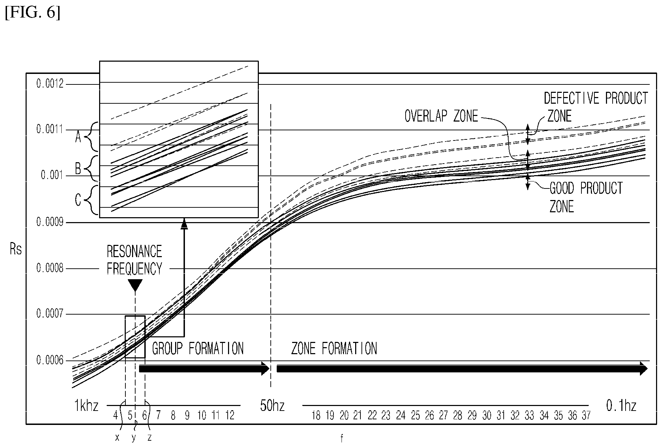

FIG. 6 is a graph for describing a process of obtaining a real part resistance value range and determining whether a battery cell is good or bad according to a method for inspecting disconnection of an electrode tab of one embodiment of the present invention.

As in FIG. 6, real part resistance values Rs according to the frequency f in the resonance frequency range of each good battery cell may be connected to derive a good product impedance real part resistance value line of each battery cell. In the present embodiment, real part resistance values Rs according to the frequency f of ten good battery cells are obtained, and the real part resistance values Rs are connected as lines.

In this case, a real part resistance value zone of the good battery cells in which the good product impedance real part resistance value lines are adjacent may be a real part resistance value range in the resonance frequency range of the good battery cells. In FIG. 6, a good product zone is illustrated over frequency f. However, as will be described below, at low frequencies, since there are many zones which overlap a real part resistance value zone of a defective product, only the real part resistance value range in the resonance frequency range is limited to the good product real part resistance value range for the disconnection inspection.

In this case, among real part resistance values Rs of the inspection target battery cell, the real part resistance values in the same frequency range as the resonance frequency range are compared with the real part resistance values of the real part resistance value zone of the good battery cells in the resonance frequency range of FIG. 6. When the former is larger than the latter, the inspection target battery cell may be determined to be a defective product, and when the former falls within the latter range or less, the inspection target battery cell may be determined to be a good product.

Alternatively, in this determination, whether a battery cell is good or bad may be determined by comparing the real part resistance values Rs of the real part resistance value zone of the good battery cells and the real part resistance values Rs of a specific battery cell at three points of a minimum frequency, a middle frequency, and a maximum frequency in the resonance frequency range. That is, since resonance frequencies of ten good battery cells span a range (resonance frequency range), comparison between the real part resistance value Rs at one point in this range may lower reliability. Accordingly, whether the battery cell is good or bad is determined by comparing the real part resistance values Rs of the good battery cells at three points of a minimum frequency z, a middle frequency y, and a maximum frequency x in the resonance frequency range of FIG. 6 with the real part resistance values Rs of the inspection target battery cell at three points of frequencies the same as the frequencies.

Although it is ideal for the good product real part resistance value range and the real part resistance value range of the defective product not to overlap, in practice, there may be an overlapping range as in FIG. 6. For example, in a plurality of (five) defective battery cells each having disconnection in an electrode tab, a defective product real part resistance value line of an individual battery cell or a defective product real part resistance value zone in which real part resistance value lines of the plurality of defective battery cells are adjacent may be obtained by connecting real part resistance values according to the frequency f of the battery cells. As in FIG. 6, the defective product real part resistance value zone overlaps the good product zone much at low frequencies. However, as illustrated in the drawing, in the resonance frequency range, the real part resistance values Rs in the defective product real part resistance value zone are relatively clearly distinguished from the real part resistance values Rs of the good product zone, and only some of the real part resistance values Rs in the defective product real part resistance value zone overlap the real part resistance values Rs of the good product zone. In this case, as described above, a range in which a good product is determined on the basis of the real part resistance values Rs may be determined by weighting and comparing viewpoints of quality standards, safety, and productivity. As in an enlarged view of FIG. 6, when quality and safety are important, portion B in which the defective product real part resistance value line or defective product real part resistance value zone overlaps the real part resistance value zone of the good battery cells is excluded, and whether the inspection target battery cell is good is determined by comparing the real part resistance value (zone) C under portion B with the real part resistance value Rs of the inspection target battery cell. When quality standards are not strict and productivity is considered, whether the inspection target battery cell is good is determined by comparing the entire good product real part resistance value range including portion B and real part resistance value (zone) C with the real part resistance value Rs of the inspection target battery cell.

### (Second embodiment)

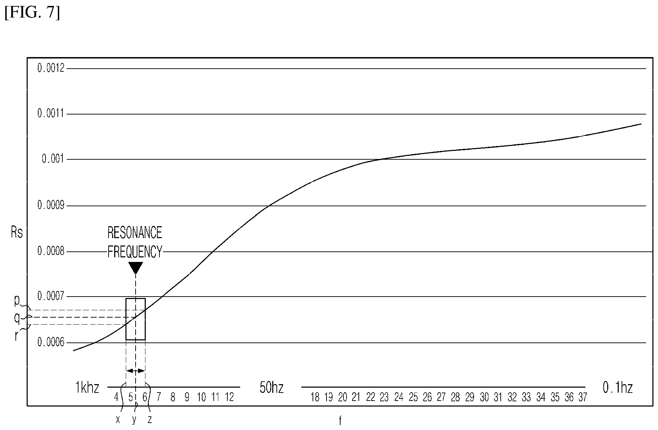

FIG. 7 is a graph for describing a process of obtaining a real part resistance value range and determining whether a battery cell is good or bad according to a method for inspecting disconnection of an electrode tab of another embodiment of the present invention.

The present embodiment, like FIG. 6, is characterized in that a real part resistance value range of good batteries is simplified through a statistical technique such as regression analysis to simplify disconnection inspection instead of combining the real part resistance value lines at the resonance frequencies of the individual good battery cells.

That is, frequency data and real part resistance value data of a plurality of (for example, 10, 100, or 1000) good battery cells in a resonance frequency range are drawn on a coordinate plane with frequency-real part resistance value Rs as in FIG. 6. In this case, as the number of battery cells increases, a dispersion of data points dotted as coordinates may also increase. Based on the data, a relational equation which appropriately reflects the data may be derived with a frequency f as an independent variable and a real part resistance value Rs as a dependent variable. That is, a correlation between pieces of data may be derived through regression analysis. The relational equation may be one of various functions such as a linear function, a quadratic function, another polynomial function, an exponential function, and a log function.

As described above, the correlation between the frequencies in the resonance frequency range and the real part resistance values Rs is derived, and a real part resistance value range in the resonance frequency range based on the derived correlation is defined as a real part resistance value range in the resonance frequency range of the good battery cells.

Referring to FIG. 7, one correlation between frequency data and real part resistance value data of ten good battery cells is illustrated.

Accordingly, in a inspection target battery cell, when real part resistance values Rs of impedance of the inspection target battery cell in the same frequency range as the resonance frequency range are greater than the real part resistance values in the resonance frequency range of the good battery cells on the basis of the correlation, the inspection target battery cell may be determined to be a defective product, and when the real part resistance values Rs of the impedance of the inspection target battery cell in the same frequency range as the resonance frequency range are smaller than the real part resistance value range in the resonance frequency range of the good battery cells on the basis of the correlation, the inspection target battery cell may be determined to be a good product.

Specifically, whether the inspection target battery cell is good or bad may be determined by comparing good product real part resistance values r, q, and p expressed as the correlation at three points of a minimum frequency z, a middle frequency y, and a maximum frequency x in the resonance frequency range with real part resistance values Rs of the specific battery cell at the three points of the frequencies.

Alternatively, in the determination, when the real part resistance values of the impedance of the specific battery cell in the same frequency range as the resonance frequency range are greater than the real part resistance values of the good battery cells in the resonance frequency range on the basis of the correlation by a predetermined range or more, the inspection target battery cell may be determined to be a defective product. Since the regression analysis models a plurality of pieces of data, errors (residuals and estimated standard errors) inevitably occur between actual measured data and data according the correlation equation. Accordingly, when the real part resistance values of the single functional relationship illustrated in FIG. 7 are compared with those of the inspection target battery cell and the real part resistance values of the inspection target battery cell are greater than the real part resistance values of the good battery cells in the resonance frequency range by a certain range (for example, a statistically generated error range) on the basis of the correlation, the inspection target battery cell may be determined to be a defective product. This is similar to excluding the real part resistance values of the good product zone overlapping those of the defective product zone in the embodiment of FIG. 6 from the real part resistance value range for determining whether disconnection occurs. Accordingly, whether the electrode tab of the battery cell is disconnected can be more strictly inspected.

As described above, in the present invention, whether the electrode tab of the battery cell is disconnected can be quickly inspected even without pressing the battery cell. That is, whether the electrode tab of the battery cell is disconnected can be inspected quickly and simply through only comparison with the real part resistance values of the good battery cells by using a conventional impedance meter such as the EIS meter and a predetermined statistical technique.

Further, according to the present invention, not only can a quick inspect be performed in a battery cell manufacturing stage, but a defect (disconnection of the electrode tab) of the battery cell in a recycling stage or reuse stage in which a finished battery cell is used again after a certain period of use can also be quickly inspected. Accordingly, when the battery cell is recycled, whether the battery is to be used can be simply determined by inspecting the defect of the battery cell.

The above description is only an example describing the present invention, and various changes, modifications, and replacements may be made by those skilled in the art without departing from the present invention. Therefore, the embodiments disclosed in the present invention are considered in a descriptive sense only and not for purposes of limitation, and the scope of the invention is not limited by the embodiments. It should be interpreted that the scope of the invention is defined by the appended claims and encompasses all modifications that fall within the scope of the appended claims.

Meanwhile, in the present specification, although terms such as, upward, downward, left, right, forward, and rearward, which indicate directions, have been used, the terms are only for the sake of convenience in the description, and it is clear that the directions change according to a position of a target object or observer.

### [Reference Numerals]

10: BATTERY CELL
11: BATTERY CASE
12: ELECTRODE ASSEMBLY
13: ELECTRODE TAB
14: ELECTRODE LEAD
15: DISCONNECTION
100: BATTERY CELL ELECTRODE TAB DISCONNECTION INSPECTION DEVICE
110: MEASUREMENT PART
120: CALCULATION PART
130: DETERMINATION PART
131, 140: STORAGE PART

## Claims

1. An apparatus (100) for inspecting disconnection of an electrode tab of a battery cell **characterized in that** the apparatus comprises:
a measurement part (110) which measures impedance values and impedance angles according to the frequency of an inspection target battery cell (10);
a calculation part (120) which calculates real part resistance values of impedance according to the frequency of the inspection target battery cell from the impedance values and the impedance angles; and
a determination part (130) which determines whether an electrode tab of the battery cell is disconnected by comparing real part resistance values in a real part resistance value range in a resonance frequency range of good battery cells having the same type as the inspection target battery cell with the real part resistance values of the impedance of the inspection target battery cell in the same frequency range as the resonance frequency range.

2. The apparatus of claim 1, wherein, when the real part resistance values of the impedance of the inspection target battery cell in the same frequency range as the resonance frequency range are greater than the real part resistance values in the real part resistance value range in the resonance frequency range of the good battery cells, the determination part determines that the electrode tab of the inspection target battery cell is disconnected.

3. The apparatus of claim 1, wherein the measurement part includes an electrochemical impedance spectroscopy (EIS) meter.

4. The apparatus of claim 1, wherein, when a part of the real part resistance value range of the good battery cells in the resonance frequency range overlaps a change line of real part resistance values of a defective battery cell or a real part resistance value range of the defective battery cells in the same frequency range as the resonance frequency range, the determination part inspects whether the electrode tab of the inspection target battery cell is disconnected by comparing the real part resistance values in the real part resistance value range of the good battery cells including or excluding the overlapping change line or range with the real part resistance values of the inspection target battery cell.

5. The apparatus of claim 1, wherein, the determination part inspects whether the electrode tab of the inspection target battery cell is disconnected by determining real part resistance values in a real part resistance value range of the good battery cells based on frequency data of the resonance frequency range of the good battery cells and real part resistance value data in the resonance frequency range and comparing the real part resistance values in the real part resistance value range of the good battery cells with the real part resistance values of the inspection target battery cell.

6. The apparatus of claim 1, further comprising a storage part in which information on at least one of the resonance frequency range of the plurality of battery cells, the real part resistance value range of the good battery cells in the resonance frequency range, and a correlation between frequencies and real part resistance values in the resonance frequency range is stored.

7. A method for inspecting disconnection of an electrode tab of a battery cell **characterized in that** the method comprises:
measuring impedance values and impedance angles according to the frequency of an inspection target battery cell;
calculating real part resistance values of impedance according to the frequency of the inspection target battery cell from the impedance values and the impedance angles; and
determining whether an electrode tab of the inspection target battery cell is disconnected by comparing real part resistance values in a real part resistance value range in a resonance frequency range of good battery cells having the same type as the inspection target battery cell with the real part resistance values of the impedance of the inspection target battery cell in the same frequency range as the resonance frequency range.

8. The method of claim 7, wherein the resonance frequency range of the good battery cells is a range of frequencies when an imaginary part resistance value of an impedance value measured for each of the plurality of good battery cells changes from a positive value to a negative value.

9. The method of claim 8, comprising:
deriving a real part resistance value line of good product impedance of the individual good battery by connecting real part resistance values according to the frequency in the resonance frequency range of each of the good battery cells ; and
setting a real part resistance value zone of the good battery cells, of which real part resistance value lines of good product impedance are adjacent, to the real part resistance value range in the resonance frequency range of the good battery cells.

10. The method of claim 9, wherein the determining includes:
determining the inspection target battery cell to be a defective product when the real part resistance values of the impedance of the inspection target battery cell in the same frequency range as the resonance frequency range are greater than the real part resistance values of the real part resistance value zone of the good battery cells; and
determining the inspection target battery cell to be a good product when the real part resistance values of the impedance of the inspection target battery cell in the same frequency range as the resonance frequency range are smaller than or equal to a range of the real part resistance values of the real part resistance value zone.

11. The method of claim 9, wherein the determining includes determining whether the inspection target battery cell is good or bad by comparing each of real part resistance values in the real part resistance value zone of the good battery cells with each of real part resistance values of the inspection target battery cell at three points of a minimum frequency, a middle frequency, and a maximum frequency in the resonance frequency range.

12. The method of claim 9, comprising:
deriving a defective product real part resistance value line of an individual battery cell or a defective real part resistance value zone in which real part resistance value lines of a plurality of defective battery cells are adjacent by connecting real part resistance values according to the frequency of each of the plurality of defective battery cells in which electrode tabs are disconnected; and
setting, when the defective product real part resistance value line or the defective product real part resistance value zone overlaps the real part resistance value zone of the good battery cells, a range including or excluding the overlapping zone or line to a real part resistance value range of the good battery cells for determining whether the battery cell is good or bad.

13. The method of claim 8, including:
deriving a correlation between frequencies and the real part resistance values in the resonance frequency range from frequency data and real part resistance value data in the resonance frequency range of the plurality of good battery cells; and
setting a real part resistance value range in the resonance frequency range based on the derived correlation to a real part resistance value range in the resonance frequency range of the good battery cells.

14. The method of claim 13, wherein the determining includes:
determining the inspection target battery cell to be a defective product when the real part resistance values of the impedance of the inspection target battery cell in the same frequency range as the resonance frequency range are greater than the real part resistance value in the resonance frequency range of the good battery cells based on the correlation; and
determining the inspection target battery cell to be a good product when the real part resistance values of the impedance of the inspection target battery cell in the same frequency range as the resonance frequency range are smaller than the real part resistance value range in the resonance frequency range of the good battery cells based on the correlation.

15. The method of claim 13, wherein the determining includes determining whether the battery cell is good or bad by comparing each of real part resistance values of the good products expressed according to the correlation at three points of a minimum frequency, a middle frequency, and a maximum frequency of the resonance frequency range with each of real part resistance values of the inspection target battery cell at the three frequencies.

## Patentansprüche

1. Vorrichtung (100) zum Untersuchen einer Trennung eines Elektrodenstreifens einer Batteriezelle, **dadurch gekennzeichnet, dass** die Vorrichtung umfasst:
einen Messteil (110), welcher Impedanzwerte und Impedanzwinkel einer Untersuchungsziel-Batteriezelle (10) abhängig von der Frequenz misst;
einen Berechnungsteil (120), welcher Realteil-Widerstandswerte einer Impedanz der Untersuchungsziel-Batteriezelle abhängig von der Frequenz aus den Impedanzwerten und den Impedanzwinkeln berechnet; und
einen Bestimmungsteil (130), welcher bestimmt, ob ein Elektrodenstreifen der Batteriezelle getrennt ist, durch Vergleichen von Realteil-Widerstandswerten in einer Realteil-Widerstandswerte-Spanne in einer Resonanzfrequenz-Spanne intakter Batteriezellen, welche die gleiche Art aufweisen wie die Untersuchungsziel-Batteriezelle, mit den Realteil-Widerstandswerten der Impedanz der Untersuchungsziel-Batteriezelle in der gleichen Frequenzspanne wie die Resonanzfrequenz-Spanne.

2. Vorrichtung nach Anspruch 1, wobei, wenn die Realteil-Widerstandswerte der Impedanz der Untersuchungsziel-Batteriezelle in der gleichen Frequenzspanne wie die Resonanzfrequenz-Spanne größer sind als die Realteil-Widerstandswerte in der Realteil-Widerstandswerte-Spanne in der Resonanzfrequenz-Spanne der intakten Batteriezellen, der Bestimmungsteil bestimmt, dass der Elektrodenstreifen der Untersuchungsziel-Batteriezelle getrennt ist.

3. Vorrichtung nach Anspruch 1, wobei der Messteil ein Elektrochemische-Impedanzspektroskopie-(EIS)-Instrument umfasst.

4. Vorrichtung nach Anspruch 1, wobei, wenn ein Teil der Realteil-Widerstandswerte-Spanne der intakten Batteriezellen in der Resonanzfrequenz-Spanne eine Änderungslinie von Realteil-Widerstandswerten einer defekten Batteriezelle oder eine Realteil-Widerstandswerte-Spanne der defekten Batteriezellen in der gleichen Frequenzspanne wie der Resonanzfrequenz-Spanne überlagert, der Bestimmungsteil untersucht, ob der Elektrodenstreifen der Untersuchungsziel-Batteriezelle getrennt ist durch Vergleichen der Realteil-Widerstandswerte in der Realteil-Widerstandswerte-Spanne der intakten Batteriezellen, umfassend oder ausschließend die überlagernde Änderungslinie oder Spanne, mit den Realteil-Widerstandswerten der Untersuchungsziel-Batteriezelle.

5. Vorrichtung nach Anspruch 1, wobei der Bestimmungsteil untersucht, ob der Elektrodenstreifen der Untersuchungsziel-Batteriezelle getrennt ist durch Bestimmen von Realteil-Widerstandswerten in einer Realteil-Widerstandswerte-Spanne der intakten Batteriezellen basierend auf Frequenzdaten der Resonanzfrequenz-Spanne der intakten Batteriezellen und Realteil-Widerstandswerte-Daten in der Resonanzfrequenz-Spanne und durch Vergleichen der Realteil-Widerstandswerte in der Realteil-Widerstandswerte-Spanne der intakten Batteriezellen mit den Realteil-Widerstandswerten der Untersuchungsziel-Batteriezelle.

6. Vorrichtung nach Anspruch 1, ferner umfassend einen Speicherteil, in welchem Informationen zu wenigstens einem aus der Resonanzfrequenz-Spanne der Mehrzahl von Batteriezellen, der Realteil-Widerstandswerte-Spanne der intakten Batteriezellen in der Resonanzfrequenz-Spanne und einer Korrelation zwischen Frequenzen und Realteil-Widerstandswerten in der Resonanzfrequenz-Spanne gespeichert sind.

7. Verfahren zum Untersuchen einer Trennung eines Elektrodenstreifens einer Batteriezelle, **gekennzeichnet dadurch, dass** das Verfahren umfasst:
Messen von Impedanzwerten und Impedanzwinkeln einer Untersuchungsziel-Batteriezelle abhängig von der Frequenz;
Berechnen von Realteil-Widerstandswerten einer Impedanz der Untersuchungsziel-Batteriezelle abhängig von der Frequenz aus den Impedanzwerten und den Impedanzwinkeln; und
Bestimmen, ob ein Elektrodenstreifen der Batteriezelle getrennt ist durch Vergleichen von Realteil-Widerstandswerten in einer Realteil-Widerstandswerte-Spanne in einer Resonanzfrequenz-Spanne intakter Batteriezellen, welche die gleiche Art aufweisen wie die Untersuchungsziel-Batteriezelle, mit den Realteil-Widerstandswerten der Impedanz der Untersuchungsziel-Batteriezelle in der gleichen Frequenzspanne wie die Resonanzfrequenz-Spanne.

8. Verfahren nach Anspruch 7, wobei die Resonanzfrequenz-Spanne der intakten Batteriezellen eine Spanne von Frequenzen ist, wenn ein Imaginärteil-Widerstandswert eines Impedanzwerts, welcher für jede der Mehrzahl von intakten Batteriezellen gemessen ist, sich von einem positiven Wert zu einem negativen Wert ändert.

9. Verfahren nach Anspruch 8, umfassend:
Erlangen einer Realteil-Widerstandswerte-Linie einer Impedanz eines intakten Produkts der individuellen intakten Batterie durch Verbinden von Realteil-Widerstandswerten von jeder der intakten Batteriezellen abhängig von der Frequenz in der Resonanzfrequenz-Spanne; und
Festlegen eines Realteil-Widerstandswerte-Bereichs der intakten Batteriezellen, von welchem Realteil-Widerstandswerte-Linien der Impedanz des intakten Produkts benachbart sind, als die Realteil-Widerstandswerte-Spanne in der Resonanzfrequenz-Spanne der intakten Batteriezellen.

10. Verfahren nach Anspruch 9, wobei das Bestimmen umfasst:
Bestimmen, dass eine Untersuchungsziel-Batteriezelle ein defektes Produkt ist, wenn die Realteil-Widerstandswerte der Impedanz der Untersuchungsziel-Batteriezelle in der gleichen Frequenzspanne wie die Resonanzfrequenz-Spanne größer sind als die Realteil-Widerstandswerte des Realteil-Widerstandswerte-Bereichs der intakten Batteriezellen; und
Bestimmen, dass die Untersuchungsziel-Batteriezelle ein intaktes Produkt ist, wenn die Realteil-Widerstandswerte der Impedanz der Untersuchungsziel-Batteriezelle in der gleichen Frequenzspanne wie die Resonanzfrequenz-Spanne kleiner als oder gleich wie eine Spanne der Realteil-Widerstandswerte des Realteil-Widerstandswerte-Bereichs sind.

11. Verfahren nach Anspruch 9, wobei das Bestimmen ein Bestimmen umfasst, ob die Untersuchungsziel-Batteriezelle intakt oder defekt ist durch Vergleichen von jedem der Realteil-Widerstandswerte in dem Realteil-Widerstandswerte-Bereich der intakten Batteriezellen mit jedem der Realteil-Widerstandswerte der Untersuchungsziel-Batteriezelle an drei Punkten einer minimalen Frequenz, einer mittleren Frequenz und einer maximalen Frequenz in der Resonanzfrequenz-Spanne.

12. Verfahren nach Anspruch 9, umfassend:
Erlangen einer Realteil-Widerstandswerte-Linie eines defekten Produkts einer individuellen Batteriezelle oder eines defekten Realteil-Widerstandswerte-Bereichs, in welchem Realteil-Widerstandswerte-Linien einer Mehrzahl von defekten Batteriezellen benachbart sind, durch Verbinden von Realteil-Widerstandswerten von jeder der Mehrzahl von defekten Batteriezellen, in welchen Elektrodenstreifen getrennt sind, abhängig von der Frequenz; und
Festlegen, wenn die Realteil-Widerstandswerte-Linie eines defekten Produkts oder der Realteil-Widerstandswerte-Bereich eines defekten Produkts den Realteil-Widerstandswerte-Bereich von intakten Batteriezellen überlagert, einer Spanne umfassend oder ausschließend den überlappenden Bereich oder die überlappende Linie als eine Realteil-Widerstandswerte-Spanne der intakten Batteriezellen zum Bestimmen, ob die Batteriezelle intakt oder defekt ist.

13. Verfahren nach Anspruch 8, umfassend:
Erlangen einer Korrelation zwischen Frequenzen und den Realteil-Widerstandswerten in der Resonanzfrequenz-Spanne von Frequenzdaten und Realteil-Widerstandswerte-Daten in der Resonanzfrequenz-Spanne der Mehrzahl von intakten Batteriezellen; und
Festlegen einer Realteil-Widerstandswerte-Spanne in der Resonanzfrequenz-Spanne basierend auf der erlangten Korrelation als eine Realteil-Widerstandswerte-Spanne in der Resonanzfrequenz-Spanne der intakten Batteriezellen.

14. Verfahren nach Anspruch 13, wobei das Bestimmen umfasst:
Bestimmen, dass die Untersuchungsziel-Batteriezelle ein defektes Produkt ist, wenn die Realteil-Widerstandswerte der Impedanz der Untersuchungsziel-Batteriezelle in der gleichen Frequenzspanne wie die Resonanzfrequenz-Spanne größer sind als der Realteil-Widerstandswert in der Resonanzfrequenz-Spanne der intakten Batteriezellen basierend auf der Korrelation; und
Bestimmen, dass die Untersuchungsziel-Batteriezelle ein intaktes Produkt ist, wenn die Realteil-Widerstandswerte der Impedanz der Untersuchungsziel-Batteriezelle in der gleichen Frequenzspanne wie die Resonanzfrequenz-Spanne kleiner sind als die Realteil-Widerstandswerte-Spanne in der Resonanzfrequenz-Spanne der intakten Batteriezellen basierend auf der Korrelation.

15. Verfahren nach Anspruch 13, wobei das Bestimmen ein Bestimmen umfasst, ob die Batteriezelle intakt oder defekt ist, durch Vergleichen von jedem der Realteil-Widerstandswerte der intakten Produkte, welche abhängig von der Korrelation an drei Punkten einer minimalen Frequenz, einer mittleren Frequenz und einer maximalen Frequenz der Resonanzfrequenz-Spanne zum Ausdruck gebracht sind, mit jedem der Realteil-Widerstandswerte der Untersuchungsziel-Batteriezelle an den drei Frequenzen.

## Revendications

1. Appareil (100) d'inspection de déconnexion d'une languette d'électrode d'une cellule de batterie **caractérisé en ce que** l'appareil comprend :
une partie de mesure (110) qui mesure des valeurs d'impédance et des angles d'impédance selon la fréquence d'une cellule de batterie cible à inspecter (10) ;
une partie de calcul (120) qui calcule des valeurs de résistance de partie réelle d'impédance selon la fréquence de la cellule de batterie cible à inspecter à partir des valeurs d'impédance et des angles d'impédance ; et
une partie de détermination (130) qui détermine si une languette d'électrode de la cellule de batterie est déconnectée ou non en comparant des valeurs de résistance de partie réelle dans une plage de valeurs de résistance de partie réelle dans une plage de fréquences de résonance de bonnes cellules de batterie ayant le même type que la cellule de batterie cible à inspecter aux valeurs de résistance de partie réelle de l'impédance de la cellule de batterie cible à inspecter dans la même plage de fréquences que la plage de fréquences de résonance.

2. Appareil selon la revendication 1, dans lequel, lorsque les valeurs de résistance de partie réelle de l'impédance de la cellule de batterie cible à inspecter dans la même plage de fréquences que la plage de fréquences de résonance sont supérieures aux valeurs de résistance de partie réelle dans la plage de valeurs de résistance de partie réelle dans la plage de fréquences de résonance des bonnes cellules de batterie, la partie de détermination détermine que la languette d'électrode de la cellule de batterie cible à inspecter est déconnectée.

3. Appareil selon la revendication 1, dans lequel la partie de mesure comporte un instrument de spectroscopie d'impédance électrochimique (SIE).

4. Appareil selon la revendication 1, dans lequel, lorsqu'une partie de la plage de valeurs de résistance de partie réelle des bonnes cellules de batterie dans la plage de fréquences de résonance chevauche une ligne de changement de valeurs de résistance de partie réelle d'une cellule de batterie défectueuse ou une plage de valeurs de résistance de partie réelle des cellules de batterie défectueuses dans la même plage de fréquences que la plage de fréquences de résonance, la partie de détermination inspecte si la languette d'électrode de la cellule de batterie cible à inspecter est déconnectée en comparant les valeurs de résistance de partie réelle dans la plage de valeurs de résistance de partie réelle des bonnes cellules de batterie comportant ou excluant la ligne de changement ou la plage de chevauchement aux valeurs de résistance de partie réelle de la cellule de batterie cible à inspecter.

5. Appareil selon la revendication 1, dans lequel la partie de détermination inspecte si la languette d'électrode de la cellule de batterie cible à inspecter est déconnectée en déterminant des valeurs de résistance de partie réelle dans une plage de valeurs de résistance de partie réelle des bonnes cellules de batterie sur la base de données de fréquence de la plage de fréquences de résonance des bonnes cellules de batterie et de données de valeurs de résistance de partie réelle dans la plage de fréquences de résonance et en comparant les valeurs de résistance de partie réelle dans la plage de valeurs de résistance de partie réelle des bonnes cellules de batterie aux valeurs de résistance de partie réelle de la cellule de batterie cible à inspecter.

6. Appareil selon la revendication **1,** comprenant en outre une partie de stockage dans laquelle sont stockées des informations sur au moins l'une de la plage de fréquences de résonance de la pluralité de cellules de batterie, de la plage de valeurs de résistance de partie réelle des bonnes cellules de batterie dans la plage de fréquences de résonance, et d'une corrélation entre des fréquences et des valeurs de résistance de partie réelle dans la plage de fréquences de résonance.

7. Procédé d'inspection de déconnexion d'une languette d'électrode d'une cellule de batterie **caractérisé en ce que** le procédé comprend :
la mesure de valeurs d'impédance et d'angles d'impédance selon la fréquence d'une cellule de batterie cible à inspecter ;
le calcul de valeurs de résistance de partie réelle d'impédance selon la fréquence de la cellule de batterie cible à inspecter à partir des valeurs d'impédance et des angles d'impédance ; et
le fait de déterminer si une languette d'électrode de la cellule de batterie cible à inspecter est déconnectée ou non en comparant des valeurs de résistance de partie réelle dans une plage de valeurs de résistance de partie réelle dans une plage de fréquences de résonance de bonnes cellules de batterie ayant le même type que la cellule de batterie cible à inspecter aux valeurs de résistance de partie réelle de l'impédance de la cellule de batterie cible à inspecter dans la même plage de fréquences que la plage de fréquences de résonance.

8. Procédé selon la revendication 7, dans lequel la plage de fréquences de résonance des bonnes cellules de batterie est une plage de fréquences lorsqu'une valeur de résistance de partie imaginaire d'une valeur d'impédance mesurée pour chacune de la pluralité de bonnes cellules de batterie passe d'une valeur positive à une valeur négative.

9. Procédé selon la revendication 8, comprenant :
la dérivation d'une ligne de valeurs de résistance de partie réelle d'impédance de bon produit de la bonne cellule de batterie individuelle en reliant des valeurs de résistance de partie réelle à la fréquence dans la plage de fréquences de résonance de chacune des bonnes cellules de batterie ; et
le réglage d'une zone de valeurs de résistance de partie réelle des bonnes cellules de batterie dans laquelle des lignes de valeurs de résistance de partie réelle d'impédance de bon produit sont adjacentes, sur la plage de valeurs de résistance de partie réelle dans la plage de fréquences de résonance des bonnes cellules de batterie.

10. Procédé selon la revendication 9, dans lequel la détermination comporte :
la détermination de la cellule de batterie cible à inspecter comme étant un produit défectueux lorsque les valeurs de résistance de partie réelle de l'impédance de la cellule de batterie cible à inspecter dans la même plage de fréquences que la plage de fréquences de résonance sont supérieures aux valeurs de résistance de partie réelle de la zone de valeurs de résistance de partie réelle des bonnes cellules de batterie ; et
la détermination de la cellule de batterie cible à inspecter comme étant un bon produit lorsque les valeurs de résistance de partie réelle de l'impédance de la cellule de batterie cible à inspecter dans la même plage de fréquences que la plage de fréquences de résonance sont inférieures ou égales à une plage des valeurs de résistance de partie réelle de la zone de valeurs de résistance de partie réelle.

11. Procédé selon la revendication 9, dans lequel la détermination comporte le fait de déterminer si la cellule de batterie cible à inspecter est bonne ou mauvaise en comparant chacune des valeurs de résistance de partie réelle dans la zone de valeurs de résistance de partie réelle des bonnes cellules de batterie à chacune des valeurs de résistance de partie réelle de la cellule de batterie cible à inspecter à trois points d'une fréquence minimale, d'une fréquence moyenne et d'une fréquence maximale dans la plage de fréquences de résonance.

12. Procédé selon la revendication 9, comprenant :
la dérivation d'une ligne de valeurs de résistance de partie réelle de produit défectueux d'une cellule de batterie individuelle ou d'une zone de valeurs de résistance de partie réelle défectueuse dans laquelle des lignes de valeurs de résistance de partie réelle d'une pluralité de cellules de batterie défectueuses sont adjacentes en reliant des valeurs de résistance de partie réelle selon la fréquence de chacune de la pluralité de cellules de batterie défectueuses dans lesquelles des languettes d'électrode sont déconnectées ; et
le réglage, lorsque la ligne de valeurs de résistance de partie réelle de produit défectueux ou la zone de valeurs de résistance de partie réelle de produit défectueux chevauche la zone de valeurs de résistance de partie réelle des bonnes cellules de batterie, d'une plage comportant ou excluant la zone ou la ligne de chevauchement sur une plage de valeurs de résistance de partie réelle des bonnes cellules de batterie pour déterminer si la cellule de batterie est bonne ou mauvaise.

13. Procédé selon la revendication 8, comportant :
la dérivation d'une corrélation entre des fréquences et les valeurs de résistance de partie réelle dans la plage de fréquences de résonance à partir de données de fréquence et de données de valeurs de résistance de partie réelle dans la plage de fréquences de résonance de la pluralité de bonnes cellules de batterie ; et
le réglage d'une plage de valeurs de résistance de partie réelle dans la plage de fréquences de résonance sur la base de la corrélation dérivée sur une plage de valeurs de résistance de partie réelle dans la plage de fréquences de résonance des bonnes cellules de batterie.

14. Procédé selon la revendication 13, dans lequel la détermination comporte :
la détermination de la cellule de batterie cible à inspecter comme étant un produit défectueux lorsque les valeurs de résistance de partie réelle de l'impédance de la cellule de batterie cible à inspecter dans la même plage de fréquences que la plage de fréquences de résonance sont supérieures à la valeur de résistance de partie réelle dans la plage de fréquences de résonance des bonnes cellules de batterie sur la base de la corrélation ; et
la détermination de la cellule de batterie cible à inspecter comme étant un bon produit lorsque les valeurs de résistance de partie réelle de l'impédance de la cellule de batterie cible à inspecter dans la même plage de fréquences que la plage de fréquences de résonance sont inférieures à la plage de valeurs de résistance de partie réelle dans la plage de fréquences de résonance des bonnes cellules de batterie sur la base de la corrélation.

15. Procédé selon la revendication 13, dans lequel la détermination comporte le fait de déterminer si la cellule de batterie cible à inspecter est bonne ou mauvaise en comparant chacune des valeurs de résistance de partie réelle des bons produits exprimés selon la corrélation à trois points d'une fréquence minimale, d'une fréquence moyenne et d'une fréquence maximale de la plage de fréquences de résonance à chacune des valeurs de résistance de partie réelle de la cellule de batterie cible à inspecter aux trois fréquences.
